# EUROPEAN PATENT APPLICATION

(11) **EP 0 785 576 A2**
(43) Date of publication of application: **23.07.1997**
(21) Application number: 96115634.6
(22) Date of filing: 30.09.1996
(51) Int. Cl.: H01L 27/02

(54) **Circuit including protection means**

(30) Priority: 29.09.1995 US 4523; 29.09.1995 US 4527
(71) Applicant: TEXAS INSTRUMENTS INCORPORATED, Dallas Texas 75265 (US)
(72) Inventor: Chen, Julian Zhiliang, Dallas, TX 75231 (US); Amerasekera, Ajith, Plano, TX 75023 (US); Vrotsos, Thomas A., Richardson, TX 75080 (US)
(74) Representative: Schwepfinger, Karl-Heinz, Dipl.-Ing.

(57) **Abstract**

The invention provides a Bipolar structure such as a silicon controlled rectifier (SCR) that exhibits advantageously low triggering and holding voltages for use in high speed (e.g., 900 MHz - >2 GHz) submicron ESD protection circuits for Bipolar/BiCMOS circuits. The Bipolar structure features a low shunt capacitance and a low series resistance on the input and output pins, allowing for the construction of ESD protection circuits having small silicon area and little to no impedance added in the signal path. In a preferred aspect of the invention, the SCR is assembled in the N-well of the Bipolar/BiCMOS device, as opposed to the P-substrate, as is customary in the prior art.

A preferred aspect of the invention utilizes a Zener diode in combination with a resistor to control BSCR operation through the NPN transistor. The turn-on voltage of the Zener is selected so as to be comparable to the emitter-base breakdown voltage of the NPN structure, which is only slightly higher than the power supply voltage to ensure that the ESD protection circuit will not be triggered under normal circuit operation. A forward diode string can optionally be added in series with the Zener to increase circuit trigger voltage, particularly in instances where the power supply voltage exceeds the Zener breakdown voltage. During an ESD event, when pad voltage exceeds Zener breakdown voltage, the Zener breaks down, and current flows through an associated (polysilicon) resistor to trigger the NPN of the Bipolar SCR and thus activate the BSCR to conduct the High ESD current from the associated, protected circuit.

## Description

### FIELD OF THE INVENTION

This invention relates generally to electronic circuits, and more particularly to electrostatic discharge (ESD) protection circuits for Bipolar/BiCMOS circuits.

### BACKGROUND OF THE INVENTION

The use of electrostatic discharge (ESD) protection circuits to protect input and output circuitry from ESD is well known, as taught in prior art U.S. Patent No. 5,268,588; U.S. Patent No. 4,896,243; U.S. Patent No. 5,077,591; U.S. Patent No. 5,060,037; U.S. Patent No. 5,012,317; U.S. Patent No. 5,225,702 and U.S. Patent No. 5,290,724 all assigned to Texas Instruments Incorporated, the assignee herein. ESD protection circuits for Bipolar/BiCMOS technologies need to be able to protect the pull-down NMOS transistor in CMOS output buffers as well as the collector-base junction in NPN output transistor and the emitter-base junctions of emitter coupled logic (ECL) devices. The protection circuit is operable to turn-on at voltages that are lower than the trigger and holding voltages of their associated devices. The ESD protection circuit should also contribute minimal capacitance and require minimal surface area in order to be effective.

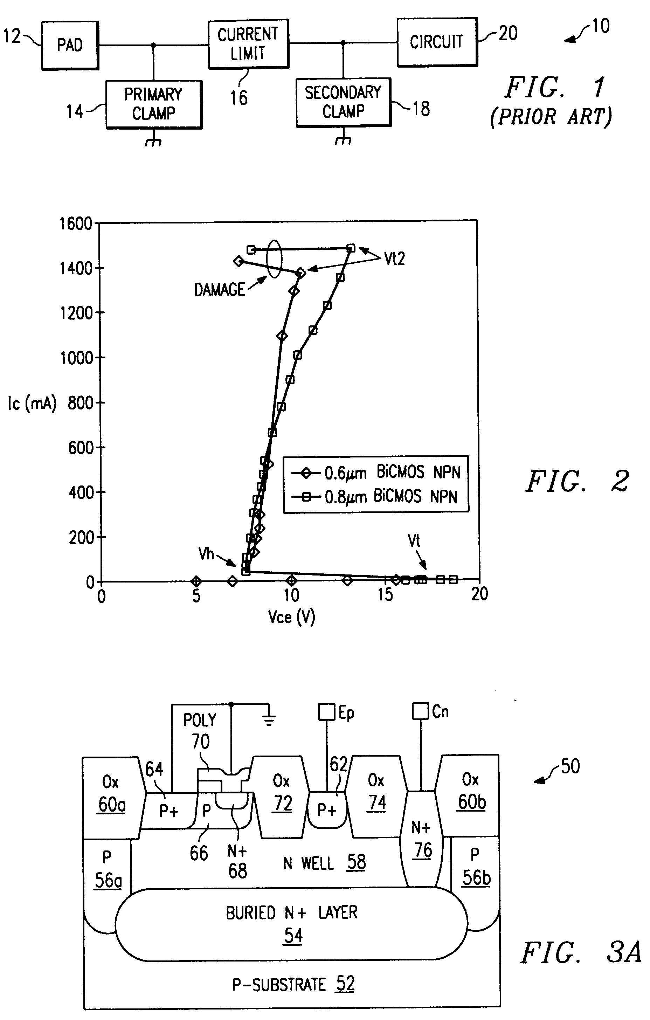

Many ESD protection circuits utilize a two stage protection scheme on circuit inputs as shown in prior art FIG. 1. Typically, the high current pulse of an ESD strike passes through the primary clamp, which clamps the pad voltage. However, this is still too high a voltage for the circuitry to receive, therefore the secondary clamp clamps the voltage to a safe value. The current limit structure restricts the current flow so that the secondary clamp does not have to be excessively large.

Present state-of-the art BiCMOS processes use NPN or SCR (silicon controlled rectifier) devices for ESD protection circuits. SCR devices designed for Bipolar circuits typically exhibit higher trigger voltages and comparable, or even lower, holding voltages as NPN transistors. As complimentary oxide semiconductor (CMOS) processes evolve to transistor shorter channel lengths and gate oxides, it becomes more difficult to protect both input and output circuits from damage due to electrostatic discharge.

High speed submicron Bipolar/BiCMOS circuit applications impose tight constraints on ESD protection circuits. Essential requirements are low shunt capacitance and low series resistance on input and output pins, which means that ESD protection circuits should require minimal silicon space and contribute virtually no impedance to the signal path. Trigger voltages (Vₜ) and clamp voltages (V_{clamp}) should also be below the "turn-on" (i.e., activation) voltages of the circuits being protected. NPN transistor ESD protection schemes have limitations for such systems. Figure 2 graphically illustrates pulsed current-voltage curves of a 100 µm wide NPN transistor in 0.6µm and 0.8 µm processes, for which the V_{clamp} is 10 volts at 1.3 amp for 0.6µm processes and 13 volts at 1.3 amp for 0.8 µm processes. These levels are too high to protect Bipolar/MOS input and output buffers as well as emitter coupled logic (ECL) devices in advanced submicron technologies. The high clamping voltage of the NPN structure is attributed to its high holding voltage (Vₕ) and the on-resistance value. In submicron Bipolar/BiCMOS processes, a protection NPN structure is normally operable in the avalanche mode in order to conduct the high ESD current. For a given process, setting of the BV_{ceo} (breakdown at collector-emitter junction, base "open") therefore establishes the lower limit of the clamping voltage V_{clamp}. Clamp voltage can be lowered by lowering the on-resistance value, which can be accomplished by using larger NPN structures and higher capacitance loading. However, such approaches are not applicable to high speed submicron Bipolar/BiCMOS processes, since a large shunt capacitance will create an electrically "shorted" path for high frequency signal input and output.

In view of the foregoing deficiencies, it would be desirable to provide circuit configurations that enable BSCR protection circuits with high ESD performance which meet the foregoing requirements of reduced triggering and holding voltages for high speed circuit applications. It would be particularly advantageous to provide a Bipolar SCR protection circuit that can be fabricated in a submicron BiCMOS in the absence of additional masks for circuit implementation.

### SUMMARY OF THE INVENTION

The invention provides a Bipolar structure such as a silicon controlled rectifier (SCR) that exhibits advantageously low triggering and holding voltages for use in high speed (e.g., 900 MHz - >2 GHz) submicron ESD protection circuits for Bipolar/BiCMOS circuits. The Bipolar structure features a low shunt capacitance and a low series resistance on the input and output pins, allowing for the construction of ESD protection circuits having small silicon area and little to no impedance added in the signal path. In a preferred aspect of the invention, the SCR is assembled in the N-well of the Bipolar/BiCMOS device, as opposed to the P-substrate, as is customary in the prior art. Moreover, a P⁺ anode implant can be provided that can be accomplished in the absence of additional mask patterning steps.

A preferred aspect of the invention utilizes a Zener diode in combination with a resistor to control BSCR operation through the NPN or PNP transistor. The turn-on voltage of the Zener diode is selected so as to be comparable to the emitter-base breakdown voltage of the NPN structure, which is only slightly higher than the power supply voltage to ensure that the ESD protection circuit will not be triggered under normal circuit operation. A forward diode string can optionally be added in series with the Zener to increase circuit trigger voltage, particularly in instances where the power supply voltage exceeds the Zener breakdown voltage. During an ESD event, when pad voltage exceeds Zener breakdown voltage, the Zener breaks down, and current flows through an associated (polysilicon) resistor to trigger the NPN or the PNP of the Bipolar SCR and thus activate the BSCR to conduct the High ESD current from the associated, protected circuit. BSCR resistance and Zener diode breakdown voltage values can be selected which permit scaling of ESD protection circuit holding and trigger voltages for optimum compatibility with the power, supply voltage.

### BRIEF DESCRIPTION OF THE DRAWINGS

Further features and advantages of the present invention will become apparent from a reading of the specification in conjunction with the drawings, for which like reference characters represent corresponding parts throughout the various views and in which certain aspects of the depicted structures have been exaggerated for clarity, in which:
FIG. 1 is a block diagram illustrating a conventional ESD protection circuit;
FIG. 2 is a current-voltage graph of 100 µm wide NPN structures in 0.6 & 0.8 µm BiCMOS processes;
FIGS. 3A and 3B are cross-sections of alternative ESD protection circuit structures in accordance with the present invention;
FIG. 4 is a schematic illustration of the ESD protection circuit depicted in FIG. 3A;
FIG. 5 is a graph of Resistor-dependent current-voltage curves for the Bipolar SCR device depicted in FIG. 3A;
FIG. 6 is a schematic illustration of an alternative Bipolar SCR protection circuit employing an NPN Zener diode and a resistor; and
FIG. 7 is a high current-voltage graph of the Bipolar SCR ESD protection circuit illustrated in FIG. 6;
FIG. 8 is a schematic illustration of an alternative Bipolar SCR ESD protection circuit that is triggered by activation of the circuit PNP; and
FIG.9 is a current-voltage graph for the circuit illustrated in FIG.8.

### DETAILED DESCRIPTION OF THE PREFERRED EMBODIMENTS

It is to be understood and appreciated that the process steps and structures described below do not form a complete process flow for the manufacture of integrated circuits. The present invention can be practiced in conjunction with integrated circuit fabrication techniques that are currently used in the art, and only so much of the commonly practiced process steps are included herein as are necessary to provide an understanding of the present invention. The drawing figures that are included with this specification and which represent cross-sections of portions of an integrated circuit during fabrication are not drawn to scale, but instead are drawn so as to illustrate the relevant features of the invention.

The ESD circuit of the present invention provides the relatively low shunt capacitance (typically <0.5pF) and no appreciable resistance on circuit input and output pads that are desired for the present and future contemplated generations of submicron Bipolar/BiCMOS circuit protection schemes. ESD protection circuits provided in accordance with the present invention are operable to protect the pull-down NMOS transistor in CMOS output buffers, the collector-base junctions in NPN output transistors, and the emitter-base junctions in ECL outputs. Such ESD protection circuitry is operable to turn-on at voltages that are typically below the trigger voltages of these respective elements, and feature a holding voltage that is lower than the turn-on or activation voltages of these devices. As will be explained below, the reduction in turn-on and holding voltages is obtained through the operation of trigger elements that can optionally be integrated with the BSCR to form a protection circuit.

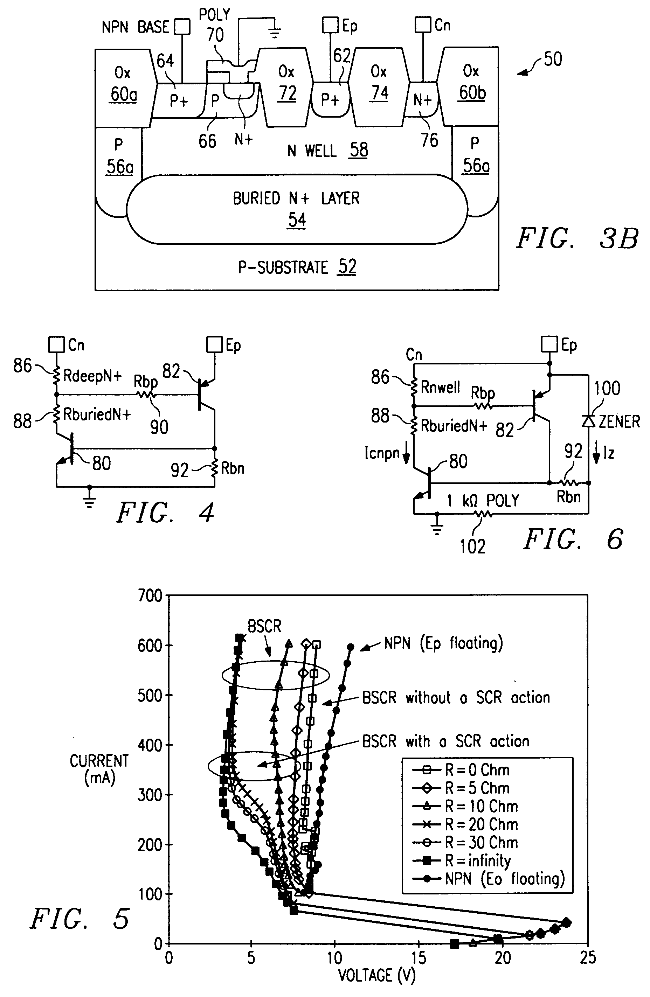

With reference to Figs. 3A & 3B, there is illustrated in cross-section an exemplary 100µm-wide Bipolar SCR ("BSCR"), designated generally by reference numeral 50, that was fabricated in an 0.8µm BiCMOS process. The circuit 50 in comprised of an P-substrate 52 which underlies a buried N⁺ layer 54. The buried N⁺ layer 54 provides a low collector resistance for a vertical NPN transistor that will be assembled on the structure, as detailed below. The buried N⁺ layer 54 is surrounded at its ends by P layers 56A and 56B, respectively, which also border the P-substrate 52. The P layers 56A & 56B extend towards the surface structure 50 so as to define an isolation region therebetween in which an N-well 58 is formed. As will be discussed below, the N-well serves as the NPN transistor collector region. Oxide layers 60A and 60B are developed in a conventional manner over P-layers 56A & 56B, respectively. A P⁺ anode diffusion layer 62 is formed during the course of base P⁺ implant 64 that is formed in a shallow P-base implant region 66. A shallow N⁺ region 68 is formed in the P-base 66 and is covered by a layer of polysilicon 70. An oxide layer 72 is developed between the P-base 66 and P⁺ anode 62. Likewise, an oxide layer is developed between the P⁺ anode 62 and an N⁺ region 76 that extends from the surface of the structure 50 and into the N-well 58, thereby serving as the NPN base contact.

The diffusion of the P⁺ anode 62 occurs during the course of the P⁺ base implant 64 and is formed in the NPN transistor N-well 58 to form an PNPN SCR structure. This P⁺ anode implant is advantageous, because it does not require additional masking incident to the process. The PNPN structure is defined by P⁺ anode 62, N-well 58, P-base 66 and N⁺ region 68. This Bipolar PNPN structure can be treated as an NPN (80) and PNP (82) transistor pair, and its representative schematic is depicted in Fig. 4. The PNP transistor 82 is represented by the P⁺ anode 62, N-well 58 and P-base 66. The NPN transistor 80 is represented by the N- well region 68, P base 66 and the N⁺ poly-emitter 68. Polysilicon layer 70 is an emitter layer which allows for formation the shallow N⁺ region 68 by diffusion. N⁺ region 76 serves as the NPN collector contact. P⁺ region 62 serves as the SCR anode.

With concurrent reference to Figs. 3 and 4, the shallow P⁺ base 64 serves both as a base for NPN transistor 80 as well as the collector of PNP transistor 82. Polysilicon region 70 and underlying N⁺ region 68 constitute the emitter for NPN transistor 80. P⁺ anode 62 serves as the emitter for PNP transistor 82. N⁺ region 76 serves as the collector contact for the NPN transistor 80. With particular reference to the circuit schematic of Fig. 4, R_{N-well} is the resistor for the N-well 58, R_{buried} N⁺ is the buried N⁺ layer resistor 88, R_{bp} is the base resistor of the PNP 90 of the PNP transistor, and R_{bn} is the base resistor 92 of the NPN transistor 80. In instances where the Collector (C_{NPN}) is shorted to the Emitter_{PNP} E_{P}, as is typical in conventional SCR configurations, the trigger voltage Vₜ is about 24 volts, as illustrated in Fig. 5. Such high trigger voltages require the use of a protection circuit that exhibits both a secondary ESD protection device and a series resistor, as is typical with conventional SCR circuits. However, the requirement for addition of a series resistor in the signal path precludes the use of such SCR circuitry in high speed submicron Bipolar/BiCMOS circuit applications. Figure 5 also illustrates that when the Collector C_{NPN} is shorted to the emitter E_{PNP}, the Bipolar SCR is provided with the same 7Volt BV_{ceo} holding voltage as that of a conventional NPN transistor, with the exception of having the lower on-resistance value paired with the on-resistance value of the NPN transistor, as shown in Fig. 5. Accordingly, the illustrated Bipolar SCR configuration shows little improvement over conventional NPN transistors in terms of trigger (Vₜ) holding (Vₕ) voltages.

Although both the NPN 80 and PNP 82 transistors are "turned on" to provide a low on-resistance, the high BV_{ceo} holding voltage indicates that there is no regenerative SCR action. The turn-on of the regenerative SCR requires that the PNP transistor 82 be biased by the NPN transistor 80 collector current, and vice versa. In the case of the NPN Collector (C_{NPN}) shorted to the PNP emitter (E_{PNP}), low base-emitter resistance of the PNP transistor 82 due to the low deep N⁺ diffusion resistance R_{deep N}⁺. This requires an additional current from the avalanching NPN collector-base junction to maintain the PNP transistor in the "on" state. For the same given current, increasing the emitter-base resistance in either of the NPN 80 or PNP 82 transistors will increase the base-emitter voltage V_{be} and, as a result, a greater collector current flows into the bipolar transistor. The larger collector current in the bipolars will eliminate the need for an additional current source from avalanche generation, allowing for the occurrence of regenerative SCR action. Hence, holding voltage can be reduced from BV_{ceo} to a lower value. For a given current, higher resistance will permit either of the NPN 80 or PNP 82 transistors to "turn on" more vigorously, resulting in a lower holding voltage Vₕ. This resistor-enhancement effect by an external PNP base-emitter resistor 90 (Fig. 4) between the NPN collector and PNP emitter is illustrated in Fig. 5. Moreover, holding voltage (Vₕ) decreases with increases in resistance (R).

As has been discussed previously, there exist two basic requirements for establishment of a desirable Bipolar SCR protection circuit. One is a low trigger voltage (Vₜ), and the other is a low holding voltage (Vₕ) resulting from a regenerative SCR action. By virtue of the Bipolar SCR design structure and circuit respectively depicted in Figs. 3 and 4, the base of the NPN transistor 80 can be externally biased. As such, this external bias provides an additional means to control the BSCR through operation of the NPN transistor 80. As has been mentioned previously, the principal concern with using a Bipolar SCR is that the BSCR does not show any significant benefit over use of an NPN transistor, in terms of triggering (Vₜ) and holding (Vₕ) voltages. The principal reason for the holding voltage being substantially similar between the BSCR and NPN transistor is that the Collector-base avalanche breakdown is required to maintain the PNP transistor 82 in the "on" state. Although, both the NPN and PNP transistors are "turned on", thereby providing a low on-resistance in the circuit, there is no regenerative SCR action in the absence of added current flow from the avalanching collector base junction. In order to lower the holding voltage, it is required that the NPN be turned on "harder", thereby providing more current through the N-well resistor (R_{N} well) to raise the base-emitter voltage of the PNP 82 and thereby turn the PNP on "harder". This can be achieved by increasing the base-emitter resistance (R_{be}). Current forced through the base-emitter resistor will then forward-bias the NPN transistor 80 and enable the transistor 80 to turn "on" in the absence of the collector-base avalanching. NPN transistor activation in this manner reduces the trigger voltage Vₜ. A further aspect of the present invention provides a Zener diode to facilitate current biasing, as will be explained below in connection with the circuit diagram illustrated in Fig. 6.

With reference to Fig. 6, there is illustrated a Bipolar SCR ESD protection circuit fabricated in 0.8µm by BiCMOS technology in accordance with the teachings of the present invention. The illustrated circuit is similar to that illustrated in Fig. 4, with the exception that an NPN Zener diode 100 and a 1K polysilicon resistor 102 are incorporated into the circuit. The Zener diode 100 is formed by the base-emitter junction of the NPN transistor 80. The turn-on voltage of the Zener diode 100 is the NPN base-emitter breakdown voltage, which is required to be slightly higher than the power supply voltages for a given process to ensure that the ESD protection circuit will not be triggered during the course of the normal circuit operation. It may be optionally desirable to provide a forward diode string (not shown) in series with the Zener diode 100 to increase the circuit trigger voltage, particularly for those Zener breakdown voltages that are lower than the power supply voltage. During an ESD event, when the pad voltage exceeds the Zener breakdown voltage, the Zener diode 100 breaks down, and the current flows through the 1K poly resistor 102 to trigger the Bipolar SCR NPN transistor, thereby turning "on" the BSCR to conduct the high ESD current.

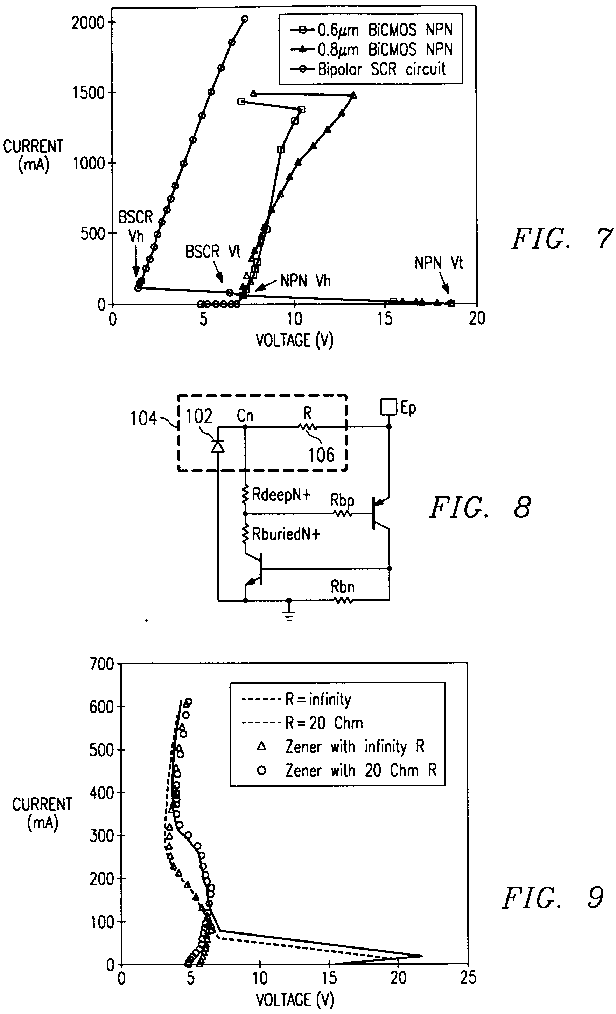

Fig. 7 illustrates a current-voltage graph for the protection circuit illustrated in Fig. 6, for which the deep N⁺ collector diffusion (N⁺ region 76 in Fig. 3B) is replaced by a more shallow N⁺ diffusion that extends into the N-well 58 rather than through the N-well 58 to the deep, buried N⁺ layer 54 of Fig. 3A. This more shallow diffusion enhances SCR action by increasing the base-emitter resistance of the PNP transistor 82.

Fig. 7 clearly demonstrates that the trigger voltage (Vₜ) can be lowered to 7V and the holding voltage (Vₕ) can be lowered to ∼1.7V. The circuit can also handle up to 2 amps ESD current while the clamp voltage is maintained at only ∼7V. Under an ESD test, the foregoing circuit with a 100 µm wide BSCR exhibits a 6.7kV ESD threshold voltage and a 3.2V/µm² ESD efficiency (as measured in ESD volt as per unit of protection circuit area). In contrast, the NPN transistor manufactured in a substantially similar process exhibits only a 2.3V/µm² efficiency. Thus, a nearly 40% ESD efficiency gain is achieved by virtue of the construction of the present invention. Stated differently, the Bipolar SCR circuit of the present invention allows for a 40% capacitance load reduction for a given ESD threshold voltage. Moreover, as is shown in the current/voltage graph of Fig. 7, the circuit can handle up to about 2 amp ESD current without any damage. At 2 amps, the clamp voltage is about 7V. In contrast, the holding and trigger voltages for an NPN transistor fabricated in a similar process are both respectively considerably higher, at about 8 and 18 volts, respectively. It can thus be appreciated that the voltage reduction levels describe above afford a considerably greater level of circuit protection than has heretofore been obtainable.

In general, the disadvantage of using SCR ESD protection is its low holding voltage, which is typically lower than the power supply voltage of many associated circuits. However, the low holding voltage is beneficial for the ESD protection. There exists a 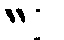 latch-up 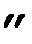 concern for such low holding voltage SCR protection, in which the BSCR has a holding voltage lower than the power supply. Under normal operation, if there is a large noise signal imposed upon one or both of the input/output (I/O) or power supply pins, the SCR ESD protection may be triggered. The SCR is then in an 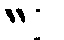 on 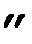 state with a low 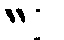 on 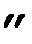 resistance and a low holding voltage, and the current will flow through the SCR from the power supply to ground and eventually cause destruction of the circuit due to Joule heating. As the power supply voltage for many portable electronic devices, such as cellular telephones and notebook computers, is expected to diminish below the present standard of about 3.3V, the need for effective ESD protection stands to become more critical.

In view of the foregoing difficulties, it would be desirable to have an adjustable holding voltage and an adjustable trigger voltage SCR so that a user could select a holding voltage having a low value for valuable ESD protection, yet higher than the power supply voltage to eliminate the problem of 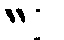 latch-up 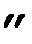 . Therefore, when the SCR is triggered by an external noise pulse that is higher than the power supply, the holding voltage would prevent the SCR from maintaining a continuous 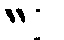 on 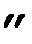 state following passage of the pulse.

With the foregoing needs and difficulties in mind, a further alternative Bipolar SCR ESD protection circuit is illustrated schematically in FIG.8. The illustrated circuit of FIG.8 addresses these problems by providing, in combination with the improved Bipolar SCR circuits discussed previously (as depicted in FIGS.4 & 6), a selectively tunable circuit that permits for adjustment of the holding voltage from about 7V (FIG.2) to about 1.7V, as shown in FIG.9. It can be appreciated that reduction of the holding voltage to the foregoing levels results in device holding voltages that are optimally slightly higher than the power supply voltage of the associated circuit.

In the embodiment depicted in FIG.8, the Bipolar SCR is triggered by turn-on of PNP transistor 82. The PNP device 82 is activated by a triggering circuit, designated generally by shadow box 104, that is comprised of a Zener diode 100' and a resistor 106 that is positioned between C_{N} and Eₚ. As holding voltage is a function of resistor value, and trigger voltage is a function of Zener breakdown voltage, resistance and breakdown voltage values for these respective components can be selected to render a protection circuit having optimal holding and triggering characteristics for a specific circuit to be protected.

When pad voltage exceeds the Zener breakdown voltage, current flows through the resistor 106 to turn 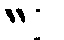 on 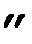 the PNP transistor 82, thus triggering the Bipolar SCR. The current-voltage graphs depicted in FIG.9 illustrate a holding voltage as low as about 3V as resistance approaches infinity. As such, selection of a specific resistance value for the resistor 106 permits tailoring of the protection circuit, and specifically its holding voltage, for the specific performance characteristics of the associated circuit to be protected.

While the invention has been described with reference to illustrative embodiments, the description is not intended to be construed in a limiting sense. Various other embodiments of the invention will be apparent to the person skilled in the art upon reference to this description.

## Claims

1. A structure for protecting a circuit from electrostatic discharge, comprising:
a first semiconductor layer (52);
a second semiconductor layer (54) overlying at least a portion of said first semiconductor layer (52);
a third semiconductor layer (58) at least partially overlying said second semiconductor layer (54);
at least two laterally spaced first implant regions (62, 64) positioned adjacent to said third semiconductor layer (58);
a second implant region (66) interposed between said at least two first implant regions (62, 64);
a third implant region (68) contacting at least a portion of said second implant region (66); and
a fourth implant region (76) laterally spaced from said third implant region (68), said first (62), second (66), third (68) implant regions, and said third semiconductor layer (58) defining a Bipolar silicon controlled rectifier.

2. The structure according to Claim 1, wherein one of said first implant regions (62,64) serves as an anode for said silicon controlled rectifier and the other of said first implant regions (62, 64) serves as a base for an npn transistor (80) and as a current guiding region for a pnp transistor (82).

3. The structure according to Claim 2, wherein said third implant region (68) comprises an emitter for said npn transistor.

4. The structure according to Claim 2 or Claim 3, further comprising a resistor (90) connected to said pnp transistor.

5. The structure according to Claim 4, wherein said resistor (90) is connected between a current guiding region of said npn transistor (80) and a current guiding region of said pnp transistor (82).

6. The structure according to any of Claims 2 to 5, further comprising a current biasing device (100) in electrical communication with said npn transistor (80).

7. The structure according to Claim 6, wherein said current biasing device comprises a Zener diode.

8. The structure according to Claim 7, further comprising a resistor (102) connected to said Zener diode (100).

9. The structure according to Claim 7 or Claim 8, wherein said Zener diode (100) is formed at a base-emitter junction of said npn transistor (80).

10. The structure according to any of Claims 6 to 9, further comprising a forward diode string connected to said current biasing device.

11. The structure according to any preceding claim, further comprising at least two laterally spaced stack regions (56a, 56b) contacting said first (52) and second (54) semiconductor layers.

12. The structure according to Claim 11, wherein an isolation region is defined by a space between said laterally spaced stack regions (56a, 56b) and said second semiconductor layer (54), said isolation region comprising said third semiconductor layer (58).

13. The structure according to Claim 1, wherein the rectifier is actuable by a triggering circuit comprising a current biasing device (100) and a resistor (106).

14. The structure according to Claim 13, wherein said first (62) and second (66) implant regions are p conductivity regions, said third implant region (68) and said third semiconductor layer (58) are n conductivity regions, thereby defining a Bipolar silicon controlled rectifier that is comprised of an npn transistor (80) and a pnp transistor (82).

15. The structure according to Claim 14, wherein said triggering circuit is interposed between a current guiding region of said npn transistor (80) and a current guiding region of said pnp transistor (82).

16. The structure according to Claim 15, wherein said npn transistor (80) current guiding region and said pnp transistor (82) current guiding region are connected to one another through a resistor.

17. The structure according to any of Claims 14 to 16, wherein said fourth implant region (76) is a deep n type diffusion contact for said npn transistor (80) current guiding region.

18. The structure according to any of Claims 13 to 17, wherein said second implant region (66) is separated from one of said first implant regions (62, 64) by an oxide layer.

19. The structure according to any of Claims 13 to 18, wherein said first (62, 64) and fourth (76) implant regions are separated by an oxide layer.

20. The structure according to any of Claims 13 to 19, wherein an oxide layer (60) is positioned in overlying relation with at least one of said stack regions (56a and 56b).

21. The structure according to any of Claims 13 to 20, wherein said fourth implant region (76) physically contacts at least said third semiconductor layer (58).

22. The structure according to Claim 21, wherein said fourth implant region (76) extends through said third semiconductor layer (58) to contact said second semiconductor layer (54).

23. The structure according to any of Claims 13 to 22, further comprising a semiconductor film (70) overlying at least a portion of said second implant region (66).

24. The structure according to Claim 22 or Claim 23, wherein at least a portion of said semiconductor film is electrically insulated from said second implant region (66).

25. The structure according to any of Claims 13 to 24, wherein one of said first implant regions (64) serves both as a base for an NPN transistor as well as a collector of a PNP transistor.

26. A structure for protecting a circuit from electrostatic discharge, comprising:
a first semiconductor layer (52);
a second semiconductor layer (54) overlying at least a portion of said first semiconductor layer (52);
a third semiconductor layer (58) at least partially overlying said second semiconductor layer (54);
at least two laterally spaced first implant regions (62, 64) positioned adjacent to said third semiconductor layer (58);
a second implant region (66) interposed between said at least two first implant regions (62, 64);
a third implant region (68) contacting at least a portion of said second implant region (66);
a fourth implant region (76) laterally spaced from said third implant region (68), wherein one of said first implant regions (62, 64) serves as an anode for said silicon controlled rectifier and the other of said first implant regions serves as a base for an npn transistor 80 and as a current guiding region for an pnp transistor 82; and
a current biasing device (100) incorporated into one of said transistors (80, 82).

27. The structure according to Claim 26, wherein said current biasing device (100) comprises a Zener diode that is connected to a base-emitter junction of said npn transistor (80).

28. The structure according to Claim 26 or Claim 27, wherein said current biasing device (100) comprises a Zener diode that is formed at a base-emitter junction of said npn transistor (80), further comprising a resistor (102) connected in series to said Zener diode.
